# EUROPÄISCHE PATENTSCHRIFT

(11) **EP 3 430 870 B1**
(45) Veröffentlichungstag und Bekanntmachung des Hinweises auf die Patenterteilung: **02.09.2020**
(21) Anmeldenummer: 17706155.3
(22) Anmeldetag: 14.02.2017
(51) Int. Cl.: H05K 7/14, H05K 7/20, H05K 1/11

(54) **ELEKTROGERÄT, AUFWEISEND EIN GEHÄUSETEIL UND EIN DECKELTEIL**
ELECTRICAL DEVICE, HAVING A HOUSING PART AND A COVER PART
APPAREIL ÉLECTROMÉNAGER, PRÉSENTANT UN ÉLÉMENT BOÎTIER ET UN ÉLÉMENT COUVERCLE

(30) Priorität: 14.03.2016 DE 102016002993
(43) Veröffentlichungstag der Anmeldung: 23.01.2019
(73) Patentinhaber: SEW-EURODRIVE GmbH & Co. KG, 76646 Bruchsal (DE)
(72) Erfinder: HANNICH, Thomas, 76646 Bruchsal (DE); KOLLAR, Hans Jürgen, 76646 Bruchsal (DE); KNELLER, Klaus, 76698 Ubstadt-Weiher (DE)
(86) Internationale Anmeldenummer: PCT/EP2017/025026
(87) Internationale Veröffentlichungsnummer: WO 2017/157527

(56) Entgegenhaltungen:
- EP-A1- 1 893 010
- EP-A2- 1 921 903
- EP-A2- 2 043 418
- DE-A1- 19 604 124
- US-A- 5 774 353
- US-B1- 8 547 699

## Beschreibung

Die Erfindung betrifft ein Elektrogerät, aufweisend ein Gehäuseteil und ein Deckelteil.

Beim Bestücken einer Leiterplatte werden die Anschlussfüsschen oder Anschlussflächen mittels Lötzinn verbunden mit Leiterbahnen der Leiterplatte. Das Bestücken bedeutet somit einerseits ein mechanisches Anordnen an der Leiterplatte und mechanisches Verbinden mit der Leiterplatte sowie andererseits ein elektrisches Verbinden.

Es ist allgemein bekannt, dass ein Deckelteil zum Abdecken einer Öffnung eines Gehäuseteils verwendbar ist.

Aus der EP 1 893 010 A1 ist als nächstliegender Stand der Technik eine Kühlanordnung bekannt.

Aus der DE 196 04 124 A1 ist ein elektrisches Gerät bekannt.

Aus der US 5 774 353 A ist eine Befestigung für ein Motorsteuerungsleistungssubstrat bekannt.

Aus der EP 1 921 903 A2 ist ein elektrisches Leistungsmodul bekannt.

Aus der EP 2 043 418 A2 ist ein Verfahren zur Reduzierung von elektromagnetischen Emissionen eines Leistungswechselrichters bekannt.

Aus der US8,547,699B1 ist ein Elektrogerät bekannt mit einem Gehäuseteil und einem Deckelteil mit jeweils darin angeordneten Leiterplatten, die elektrisch verbunden sind.

J Der Erfindung liegt daher die Aufgabe zugrunde, ein Elektrogerät, aufweisend ein Gehäuseteil und ein Deckelteil, weiterzubilden.

Erfindungsgemäß wird die Aufgabe bei dem Elektrogerät nach den in Anspruch 1 angegebenen Merkmalen gelöst.

Wichtige Merkmale der Erfindung bei dem Elektrogerät sind, dass das Elektrogerät ein Gehäuseteil und ein Deckelteil aufweist,
wobei das Deckelteil mit dem Gehäuseteil verbunden ist, insbesondere schraubverbunden ist,

insbesondere wobei das Deckelteil eine Öffnung des Gehäuseteils abdeckt,
wobei eine erste Leiterplatte mit dem Deckelteil verbunden ist,
wobei zumindest ein Wärme erzeugendes Bauteil, insbesondere steuerbarer Halbleiterschalter, von einem elastisch vorgespannten Blechteil, insbesondere von einem elastisch vorgespannten Zungenabschnitt eines Blechteils, zum Deckelteil hin gedrückt sind, insbesondere zur Wärmabfuhr vom Wärme erzeugenden Bauteil über das Deckelteil zur Umgebung hin.

Von Vorteil ist dabei, dass ein bloßes Deckelteil ersetzbar ist durch ein deckelteil, an welchem eine elektronische Schaltung, umfassend das Wärme erzeugende Bauteil, anordenbar ist. Somit ist als elektronische Schaltung beispielsweise ein schaltnetzteil vorsehbar, also am Deckelteil integrierbar. Auf diese Weise sind dem Elektrogerät verschiedene Versorgungsspannungen zur Verfügung stellbar, wodurch entsprechende Baugruppen versorgbar sind. Die Verlustwärme des Bauteils ist über das Deckelteil an die Umgebung abführbar. Dabei spreizt das Deckelteil die Wärme auf, da es metallisch, insbesondere als Metalldruckgussteil, herstellbar ist und somit gut wärmeleitend ist.

Bei einer vorteilhaften Ausgestaltung ist das Deckelteil als Metalldruckgussteil hergestellt. Von Vorteil ist dabei, dass eine kostengünstige einfache Herstellung ermöglicht ist.

Bei einer vorteilhaften Ausgestaltung sind die Wärme erzeugenden Bauteile auf einer ersten Leiterplatte bestückt.

Die erste Leiterplatte ist durch zumindest teilweises Einstecken in ein auf einer zweiten Leiterplatte angeordnetes Steckverbinderteil mit der zweiten Leiterplatte verbunden.

Die zweite Leiterplatte ist mit dem Gehäuseteil verbunden, insbesondere schraubverbunden.

Von Vorteil ist dabei, dass die auf der ersten Leiterplatte erzeugten Spannungen den auf der zweiten Leiterplatte angeordneten oder den mit der zweiten Leiterplatte elektrisch verbundenen Baugruppen zur Verfügung stellbar ist. Dabei ist beim Aufstecken des Deckelteils auf das Gehäuseteil gleichzeitig die Öffnung des Gehäuseteils verschließbar und die elektrische Steckverbindung betätigbar. Zum Führen und Zentrieren beim Einstecken sind am Deckelteil ein Steckabschnitt ausgeformt und am Gehäuseteil entsprechend Absätze als Anliegebegrenzungen beim Aufschieben des Deckelteils.

Weiterhin ist das Blechteil von einem Schraubteil, insbesondere von einem Schraubenkopf des Schraubteils, zum Deckelteil hin elastisch vorgespannt gehalten. Von Vorteil ist dabei, dass ein elastisches Andrücken gewährleistet ist und somit eine effiziente Wärmeabfuhr.

Bei einer vorteilhaften Ausgestaltung ist die erste Leiterplatte von einem oder dem Schraubteil, insbesondere von einem Absatz des Schraubteils, ans Deckelteil angedrückt. Von Vorteil ist dabei, dass das Schraubteil mehrere Funktionen ausführt, also einerseits das Andrücken der ersten Leiterplatte und andererseits das elastische Vorspannen des Blechteils, das wiederum das Bauteil gegen das Deckelteil drückt. Auf diese Weise ist eine einfache Verbindungstechnik realisiert, die gleichzeitig eine gute Wärmeabfuhr sichert.

Bei einer vorteilhaften Ausgestaltung ist das die Wärme erzeugenden Bauteile in einer durchgehenden Ausnehmung der Leiterplatte angeordnet,

insbesondere so dass der für die erste Leiterplatte als Auflagefläche fungierende Auflageabschnitt des Deckelteils geringer beabstandet ist von der Leiterplatte als der als Auflagefläche für das Wärme erzeugende Bauteil fungierende Auflageabschnitt des Deckelteils,

insbesondere wobei der für die erste Leiterplatte als Auflagefläche fungierende Auflageabschnitt des Deckelteils die Leiterplatte berührt, also verschwindenden Abstand, zur Leiterplatte aufweist. Von Vorteil ist dabei, dass das Bauteil mit seinen Anschlussbeinchen lötverbindbar ist mit Leiterbahnen der Leiterplatte. Somit ist das Bauteil schwebend in der Ausnehmung anordenbar und wird dann von dem Zungenabschnitt des Blechteils, welches auf die vom Deckelteil abgewandte Seite des Bauteils drückt, gegen die Auflagefläche, also den vertieft angeordneten Auflageabschnitt des Deckelteils gedrückt.

Bei einer vorteilhaften Ausgestaltung weist das Deckelteil einen Schlitz, insbesondere einen durchgehenden Schlitz, auf,
wobei ein Laschenabschnitt des Blechteils in den Schlitz zumindest teilweise hineinragt oder hindurchragt. Von Vorteil ist dabei, dass zum stabilen Halten des Blechteils eine oder zwei schraubteile genügen. Denn der Schlitz dient als dritte oder vierte Auflagepunkt und sichert somit das Blechteil. Außerdem wirkt der Schlitz auch als Begrenzung, so dass das Blechteil sich nicht weiter seitlich verschieben kann. Durch das Vorspannen mittels des oder der Schraubteile ist das Blechteil außerdem im Schlitz ans Gehäuseteil angedrückt und zusätzlich sicher gehalten.

Bei einer vorteilhaften Ausgestaltung weist das Deckelteil einen Steckabschnitt auf, der an einen Absatz angrenzt,
wobei der Absatz an einem Abschnitt der Berandung der Öffnung des Gehäuseteils anliegt,
wobei der Steckabschnitt an einem Teilbereich der Wandung des Gehäuseteils anliegt. Von Vorteil ist dabei, dass der Steckabschnitt ein einfaches Führen und Zentrieren beim Einstecken ins Gehäuseteil bewirkt.

Bei einer vorteilhaften Ausgestaltung weist das Gehäuseteil Kühlrippen auf zur Abfuhr von Verlustwärme von Bauteilen, insbesondere steuerbaren Halbleiterschaltern, welche auf der zweiten Leiterplatte bestückt sind oder mit dieser elektrisch verbunden sind,
wobei ein Lüfter in einer Gehäusetasche des Gehäuseteils eingeführt ist, wobei der vom Lüfter geförderte Luftstrom entlang der Kühlrippen des Gehäuseteils entlangströmt. Von Vorteil ist dabei, dass ein effektives Entwärmen des Elektrogeräts ermöglicht ist. Außerdem ist sogar ein Wärmstrom vom Deckelteil über das Gehäuseteil an die Umgebung abführbar, insbesondere bei starkem vom Lüfter gefördertem Luftstrom.

Bei einer vorteilhaften Ausgestaltung ist das Elektrogerät ein Wechselrichter, ein Umrichter oder ein Teil derselben. Von Vorteil ist dabei, dass optional das Deckelteil mit der Leiterplatte und darauf vorgesehener Schaltnetzteilelektronik einsetzbar ist statt eines bloßen Deckelteils.

Weitere Vorteile ergeben sich aus den Unteransprüchen. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von Abbildungen näher erläutert:
In der Figur 1 ist das Gehäuseteil 1 in Schrägansicht gezeigt, wobei das Gehäuseteil 1 eine Öffnung aufweist, die mit einem Deckelteil 20 abdeckbar ist.

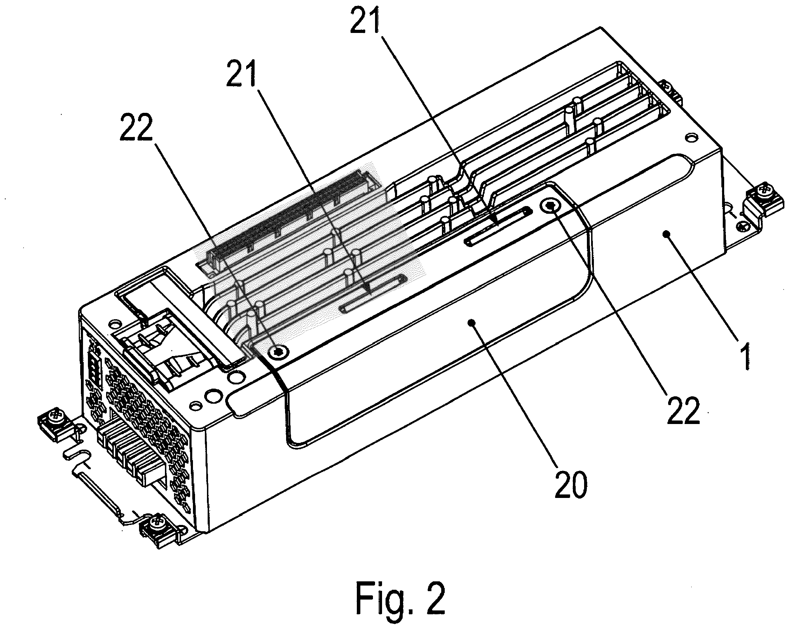

In der Figur 2 ist das Gehäuseteil 1 mit Deckelteil 20 gezeigt, das aufgesetzt auf das Gehäuseteil 1 ist und die Öffnung abdeckt.
In der Figur 3 ist das Deckelteil 20 aus einer anderen Blickrichtung gezeigt, wobei eine erste Leiterplatte 33 an der Innenseite des Deckelteils 20 angeordnet ist.
In der Figur 4 ist das bloße Deckelteil 20 gezeigt.
In der Figur 5 ist das Deckelteil 20 aus einer anderen Blickrichtung gezeigt.

Wie in den Figuren gezeigt, weist das erfindüngsgemäße Elektrogerät ein Gehäuseteil 1 mit einer Öffnung auf.

Durch Schraubverbinden des Deckelteils 20 mit dem Gehäuseteil 1 ist die Öffnung verschließbar.

Das Elektrogerät ist beispielsweise ein Umrichter, ein Wechselrichter oder ein Teil derselben.

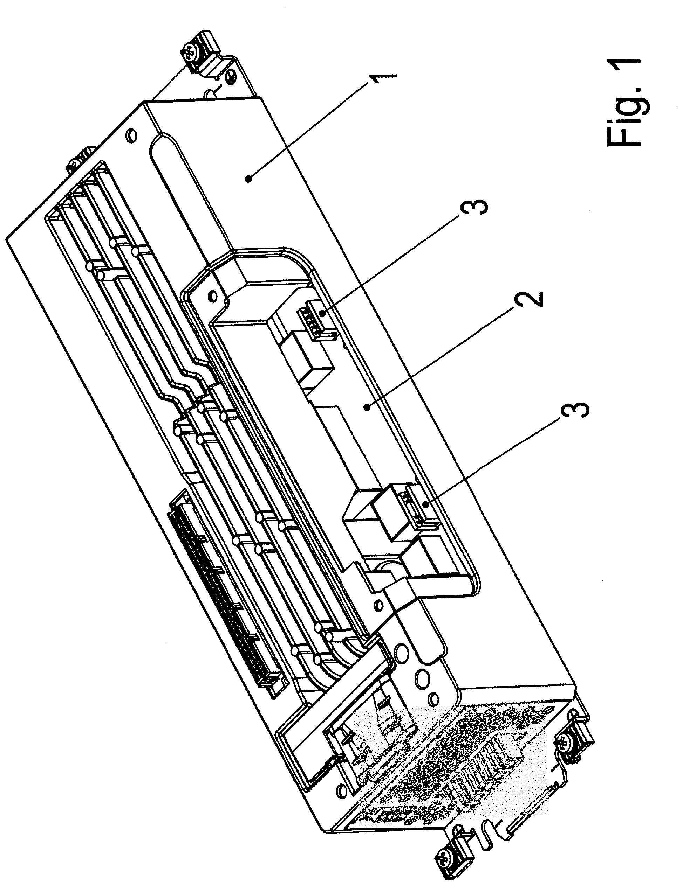

Wie in Figur 1 gezeigt, ist im Gehäuseteil 1 eine zweite Leiterplatte 2 angeordnet, welche mit elektronischen Bauelementen bestückt ist und zumindest auch mit einem Steckverbinderteil 3.

Beispielsweise sind als Bauelemente die steuerbaren Halbleiterschalter eines Wechselrichters elektrisch mit Leiterbahnen der zweiten Leiterplatte 2 verbunden. Das Gehäuseteil 1 ist vorzugsweise als Druckgussteil ausgeführt und weist auch Kühlrippen auf, an welche die von den auf der zweiten Leiterplatte 2 bestückten, steuerbaren Halbleiterschaltern erzeugte Wärme abgeführt wird.

Die Öffnung ist seitlich der Kühlrippen am Gehäuseteil 1 angeordnet.
Im Gehäuseteil 1 sind Gewindebohrungen eingebracht, in welche Verbindungsschrauben 22 einschraubbar sind, deren Schraubenköpfe jeweils das Deckelteil 1 ans Gehäuseteil 1 andrücken.

Das Deckelteil 20 weist zwei durchgehende Schlitze 21 auf, wobei in den jeweiligen Schlitz 21 ein jeweiliger Laschenabschnitt eines Blechteils 30 eingesteckt ist.

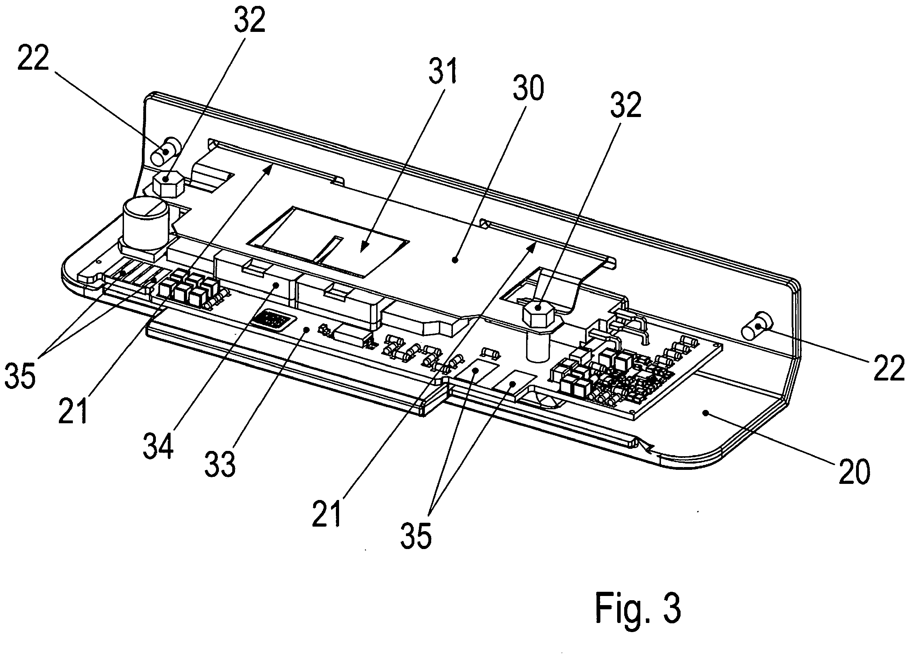

Wie in Figur 3 gezeigt, sind Schrauben 32 mit ihrem jeweiligen Gewindeabschnitt in jeweilige Gewindebohrungen eingeschraubt, die jeweils in einem ersten Auflageabschnitt 41 angeordnet sind. Das Blechteil 30 ist durch die Schraubenköpfe der Schrauben 32 begrenzt und zum Deckelteil 20 hin gedrückt.

Der jeweilige Gewindeabschnitt der Schrauben 32 ist in der Figur 3 nicht sichtbar.

Die Schrauben 32 weisen einen Absatz auf, an welchem die Leiterplatte 33 anliegt und somit von der jeweiligen Schraube 32 zum Deckelteil 20 hin gedrückt wird.

Das Blechteil 30 weist einen Zungenabschnitt 31 auf, der elastisch vorgespannt auf ein Wärme erzeugendes Bauteil 34 drückt und dieses Bauteil 34 somit zum auflageabschnitt 40 hin drückt, welche an der Innenseite des Deckelteils 20 angeordnet ist.

Die Bauteile 34 sind mit ihren Anschlussbeinchen lötverbunden mit Leiterbahnen der Leiterplatte 33.

Mittels Leiterbahnen 35 wird beim Aufstecken und Anschrauben des Deckelteils 20 an das Gehäuseteil 1 die Leiterplatte 33 mit ihren Leiterbahnen 35 in ein entsprechendes Steckverbinderteil 3 eingesteckt, welches auf der zweiten Leiterplatte 2 angeordnet ist. Somit ist eine elektrische Kontaktierung zwischen erster und zweiter Leiterplatte (2, 33) erreicht.

Auf der Leiterplatte 33 ist die ein schaltnetzteil angeordnet, also eine elektronische Schaltung zum Erzeugen verschiedener Versorgungsspannungen für die elektronischen Baugruppen des Elektrogeräts.

Beim Einstecken der Leiterbahnen 35 in das Steckverbinderteil 3, das auf der zweiten Leiterplatte 2 bestückt ist, kontaktieren Federkontakte des Steckverbinderteils 3 die Leiterbahnen 35 der ersten Leiterplatte 33. Somit sind die erzeugten Spannungen bereit stellbar für die übrigen elektrischen Baugruppen des Elektrogeräts, insbesondere für die auf der Leiterplatte 2 angeordneten Baugruppen.

Der Auflageabschnitt 40 für Bauteil 34 ist vertieft gegenüber dem ersten Auflageabschnitt 41 und zweiten Auflageabschnitt 42 für Leiterplatte 33 ausgeführt. Somit ist das Blechteil 30 entsprechend eben ausführbar und der Zungenabschnitt 31 als ausgestanzter Abschnitt herstellbar.

Das Deckelteil 20 ist als Druckgussteil ausgeführt und deckt die Öffnung, also den offenen Schacht, des Gehäuseteils 1 ab.

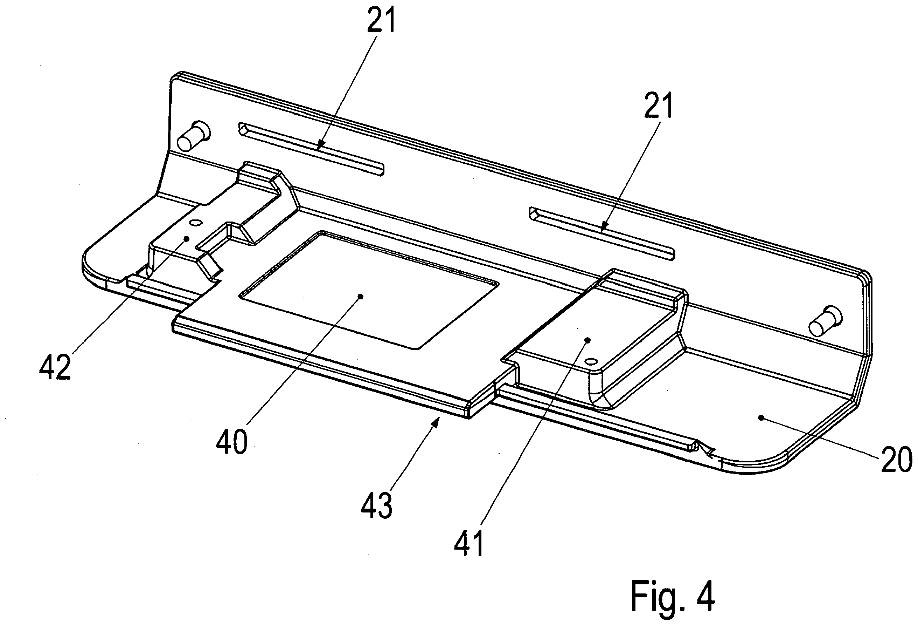

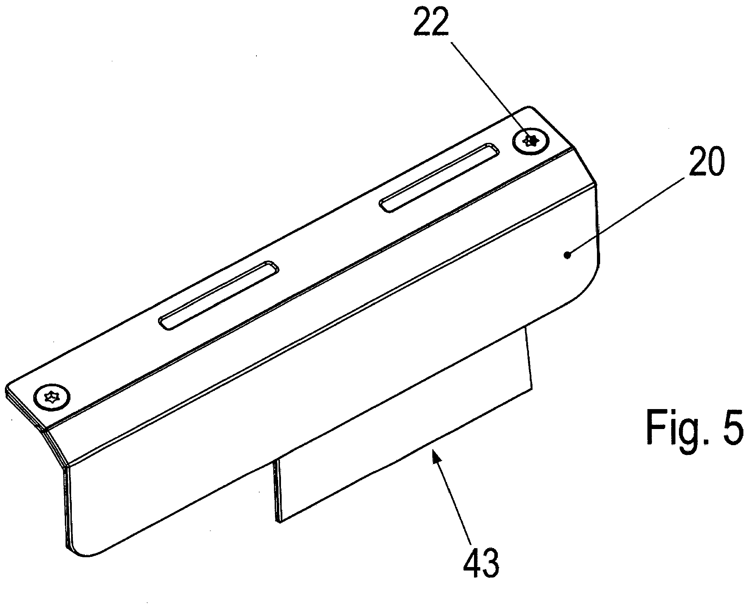

Wie in den Figuren 4 und 5 gezeigt, weist das Deckelteil 20 einen Steckabschnitt 43 auf, welcher zur Auflagefläche 40 hin einen Absatz aufweist, so dass beim Aufstecken des Deckelteils 20 ein Bereich der Berandung der Öffnung, also ein Bereich der Wandung des Gehäuseteils 1, am Absatz anliegt und der Steckabschnitt 43 an der Innenseite der Wandung des Gehäuseteils 1 anliegt.

Somit dient der Steckabschnitt 43 der genaueren Positionierung des Deckelteils 20 zum Gehäuseteil 1 hin.

Das Deckelteil 20 fungiert auch als Wärme aufspreizender Kühlkörper. Denn die von den Wärme erzeugenden Bauteilen, also von den steuerbaren Halbleiterschaltern, erzeugte Wärme, also Verlustwärme, wird dem Deckelteil 20 zugeführt und dort aufgespreizt, da dieses metallisch und somit gut wärmeleitfähig ist. Über die Außenseite des Deckelteils 20 wird ein großer Teil der Wärme an die Umgebung abgeführt. Aber auch zum Gehäuseteil 1 wird ein Wärmestrom weitergeleitet.

Das Schraubteil 32 weist also jeweils einen Schraubenkopf auf, der breiter ist, insbesondere also einen größeren Durchmesser aufweist, als ein axial nachfolgender zylindrischen Abschnitt des Schraubteils 32. Der Gewindeabschnitt des Schraubteils 32 ist auf der axial von diesem zylindrischen Abschnitt axial abgewandten Bereich angeordnet. Somit ist im Wesentlichen ein monoton abnehmender Durchmesser realisiert in axialer Richtung, also vom Schraubenkopf zum Gewindeabschnitt des Schraubteils 32

Das Gehäuseteil 1 ist einteilig ausgeführt. Bei weiteren erfindungsgemäßen Ausführungsbeispielen ist auch ein mehrteiliges Ausführen des Gehäuseteils 1 realisierbar, wobei dann allerdings Verbindungsteile zusätzlich notwendig sind.

### Bezugszeichenliste

- 1: Gehäuseteil
- 2: zweite Leiterplatte
- 3: Steckverbinderteil
- 20: Deckelteil
- 21: Schlitze, insbesondere durchgehende schlitze
- 22: Verbindungsschrauben
- 30: Blechteil
- 31: Zungenabschnitt des Blechteils 30
- 32: Schraubteil
- 33: Leiterplatte
- 34: Wärme erzeugendes Bauteil, insbesondere steuerbarer Halbleiterschalter
- 35: Leiterbahnen der Leiterplatte 33
- 40: Auflageabschnitt für Bauteil 34
- 41: erste Auflageabschnitt für Leiterplatte 33
- 42: zweite Auflageabschnitt für Leiterplatte 33
- 43: Steckabschnitt

## Patentansprüche

1. Elektrogerät, aufweisend ein Gehäuseteil (1) und ein Deckelteil (20),
wobei das Deckelteil (20) mit dem Gehäuseteil (1) verbunden ist, insbesondere wobei das Deckelteil (20) eine Öffnung des Gehäuseteils (1) abdeckt,
**wobei** eine erste Leiterplatte (33) mit dem Deckelteil (20) verbunden ist,
wobei die erste Leiterplatte (33) an der Innenseite des Deckelteils angeordnet ist,
wobei zumindest ein Wärme erzeugendes Bauteil (34), von einem elastisch vorgespannten Blechteil (30), zum Deckelteil (20) hin gedrückt wird,
wobei das Wärme erzeugende Bauteil (34) mit Leiterbahnen (35) der ersten Leiterplatte (33) elektrisch verbunden ist, wobei das Blechteil (30) von in Gewindebohrungen des Deckelteils (20) eingeschraubten Schraubteilen (32) zum Deckelteil (20) hin elastisch vorgespannt gehalten ist,
wobei die erste Leiterplatte (33) durch zumindest teilweises Einstecken in ein auf einer zweiten Leiterplatte (2) angeordnetes Steckverbinderteil (3) mit der zweiten Leiterplatte (2) elektrisch verbunden ist,
wobei die zweite Leiterplatte (2) in dem Gehäuseteil (1) angeordnet und mit diesem verbunden ist.

2. Elektrogerät nach Anspruch 1,
**dadurch gekennzeichnet, dass**
das Deckelteil (20) metallisch ausgeführt ist, insbesondere als Metalldruckgussteil hergestellt ist.

3. Elektrogerät nach mindestens einem der vorangegangenen Ansprüche,
**dadurch gekennzeichnet, dass**
das Wärme erzeugende Bauteil (34) mit Leiterbahnen (35) einer ersten Leiterplatte (33) elektrisch verbunden ist, und auf der ersten Leiterplatte (33) bestückt ist,
wobei Leiterbahnen (35) der ersten Leiterplatte (33) mittels des zumindest teilweisen Einsteckens in das Steckverbinderteil (3) elektrisch verbunden sind mit Leiterbahnen der zweiten Leiterplatte (2).

4. Elektrogerät nach mindestens einem der vorangegangenen Ansprüche,
**dadurch gekennzeichnet, dass**
die erste Leiterplatte (33) von einem oder dem Schraubteil (32), insbesondere von einem Absatz des Schraubteils (32), ans Deckelteil (20) angedrückt ist.

5. Elektrogerät nach mindestens einem der vorangegangenen Ansprüche,
**dadurch gekennzeichnet, dass**
das Wärme erzeugende Bauteil (34) in einer durchgehenden Ausnehmung der Leiterplatte (33) angeordnet ist,
so dass der für die erste Leiterplatte (33) als Auflagefläche fungierende Auflageabschnitt (40) des Deckelteils geringer beabstandet ist von der Leiterplatte (33) als der als Auflagefläche für das Wärme erzeugende Bauteil (34) fungierende Auflageabschnitt (40) des Deckelteils,
wobei der für die erste Leiterplatte (33) als Auflagefläche fungierende Auflageabschnitt (40) des Deckelteils die Leiterplatte (33) berührt, also verschwindenden Abstand zur Leiterplatte (33) aufweist.

6. Elektrogerät nach mindestens einem der vorangegangenen Ansprüche,
**dadurch gekennzeichnet, dass**
das **Deckelteil (20)** einen Schlitz, insbesondere einen durchgehenden Schlitz, aufweist,
wobei ein Laschenabschnitt des Blechteils (30) in den Schlitz zumindest teilweise hineinragt oder hindurchragt.

7. Elektrogerät nach mindestens einem der vorangegangenen Ansprüche,
**dadurch gekennzeichnet, dass**
das Deckelteil (20) einen Steckabschnitt (43) aufweist, der an einen Absatz angrenzt,
wobei der Absatz an einem Abschnitt der Berandung der Öffnung des Gehäuseteils (1) anliegt,
wobei der Steckabschnitt (43) an einem Teilbereich der Wandung des Gehäuseteils (1) anliegt.

8. Elektrogerät nach mindestens einem der vorangegangenen Ansprüche,
**dadurch gekennzeichnet, dass**
das Gehäuseteil (1) Kühlrippen aufweist zur Abfuhr von Verlustwärme von Bauteilen (34), insbesondere steuerbaren Halbleiterschaltern, welche auf der zweiten Leiterplatte (2) bestückt sind oder mit dieser elektrisch verbunden sind,
wobei ein Lüfter in einer Gehäusetasche des Gehäuseteils (1) eingeführt ist, wobei der vom Lüfter geförderte Luftstrom entlang der Kühlrippen des Gehäuseteils (1) entlangströmt.

9. Elektrogerät nach mindestens einem der vorangegangenen Ansprüche,
**dadurch gekennzeichnet, dass**
das Elektrogerät ein Wechselrichter, ein Umrichter oder ein Teil derselben ist.

## Claims

1. An electrical device having a housing part (1) and a cover part (20),
wherein the cover part (20) is connected to the housing part (1),
in particular wherein the cover part (20) covers an opening of the housing part (1),
wherein a first printed circuit board (33) is connected to the cover part (20),
wherein the first printed circuit board (33) is arranged at the inner side of the cover part,
wherein at least one component part (34) producing heat is pressed towards the cover part (20) by an elastically pre-stressed sheet-metal part (30),
wherein the heat-producing component part (34) is electrically connected to conducting tracks (35) of the first printed circuit board (33),
wherein the sheet-metal part (30) is held in a manner elastically pre-stressed towards the cover part (20) by screw parts (32) screwed into tapped holes of the cover part (20),
wherein the first printed circuit board (33) is electrically connected to the second printed circuit board (2) by at least partial plugging into a plug-and-socket connector part (3) arranged on a second printed circuit board (2),
wherein the second printed circuit board (2) is arranged in the housing part (1) and is connected thereto.

2. An electrical device according to claim 1,
**characterised in that**
the cover part (20) is metallic, in particular is manufactured as a metal die cast part.

3. An electrical device according to at least one of the preceding claims,
**characterised in that**
the heat-producing component part (34) is electrically connected to conducting tracks (35) of a first printed circuit board (33) and is fitted on the first printed circuit board (33),
wherein conducting tracks (35) of the first printed circuit board (33) are electrically connected to conducting tracks of the second printed circuit board (2) by means of the at least partial plugging into the plug-and-socket connector part (3).

4. An electrical device according to at least one of the preceding claims,
**characterised in that**
the first printed circuit board (33) is pressed against the cover part (20) by a or the screw part (32), in particular by a shoulder of the screw part (32).

5. An electrical device according to at least one of the preceding claims,
**characterised in that**
the heat-producing component part (34) is arranged in a through opening of the printed circuit board (33),
so that the bearing portion (40), acting as a bearing surface for the first printed circuit board (33), of the cover part is at a smaller distance from the printed circuit board (33) than the bearing portion (40), acting as a bearing surface for the heat-producing component part (34), of the cover part,
wherein the bearing portion (40), acting as a bearing surface for the first printed circuit board (33), of the cover part contacts the printed circuit board (33), therefore is at an insignificant distance from the printed circuit board (33).

6. An electrical device according to at least one of the preceding claims,
**characterised in that**
the cover part (20) has a slot, in particular a through slot,
wherein a tab portion of the sheet-metal part (30) projects through or at least partially into the slot.

7. An electrical device according to at least one of the preceding claims,
**characterised in that**
the cover part (20) has a plug-in portion (43) which adjoins a shoulder,
wherein the shoulder contacts a portion of the boundary of the opening of the housing part (1), wherein the plug-in portion (43) contacts a partial region of the wall of the housing part (1).

8. An electrical device according to at least one of the preceding claims,
**characterised in that**
the housing part (1) has cooling ribs for the carrying away of heat loss from component parts (34), in particular controllable semiconductor switches, which are fitted on the second printed circuit board (2) or are electrically connected thererto,
wherein a fan is inserted in a housing pocket of the housing part (1), wherein the air flow conveyed by the fan flows along the cooling ribs of the housing part (1).

9. An electrical device according to at least one of the preceding claims,
**characterised in that**
the electrical device is an inverter, a converter or a part thereof.

## Revendications

1. Appareil électrique présentant une partie boîtier (1) et une partie couvercle (20),
dans lequel la partie couvercle (20) est reliée à la partie boîtier (1),
en particulier dans lequel la partie couvercle (20) recouvre une ouverture de la partie boîtier (1),
dans lequel une première carte de circuit imprimé (33) est reliée à la partie couvercle (20),
dans lequel la première carte de circuit imprimé (33) est disposée sur le côté intérieur de la partie couvercle,
dans lequel au moins un composant produisant de la chaleur (34) est pressé vers la partie couvercle (20) par une pièce de tôle (30) précontrainte élastiquement,
dans lequel le composant produisant de la chaleur (34) est relié électriquement à des pistes conductrices (35) de la première carte de circuit imprimé (33),
dans lequel la pièce de tôle (30) est maintenue sous précontrainte élastique vers la partie couvercle (20) par des pièces filetées (32) vissées dans des trous filetés de la partie couvercle (20),
dans lequel la première carte de circuit imprimé (33) est reliée électriquement à une deuxième carte de circuit imprimé (2) par insertion au moins partielle dans une partie connecteur (3) disposée sur la deuxième carte de circuit imprimé (2),
dans lequel la deuxième carte de circuit imprimé (2) est disposée dans la partie boîtier (1) et reliée à celle-ci.

2. Appareil électrique selon la revendication 1,
**caractérisé en ce que**
la partie couvercle (20) est réalisée en métal, en particulier est fabriquée sous la forme d'une pièce métallique moulée sous pression.

3. Appareil électrique selon au moins l'une des revendications précédentes,
**caractérisé en ce que**
le composant produisant de la chaleur (34) est relié électriquement à des pistes conductrices (35) d'une première carte de circuit imprimé (33) et est monté sur la première carte de circuit imprimé (33),
dans lequel des pistes conductrices (35) de la première carte de circuit imprimé (33) sont reliées électriquement à des pistes conductrices de la deuxième carte de circuit imprimé (2) par l'insertion au moins partielle dans la partie connecteur (3).

4. Appareil électrique selon au moins l'une des revendications précédentes,
**caractérisé en ce que**
la première carte de circuit imprimé (33) est pressée contre la partie couvercle (20) par une ou la pièce filetée (32), en particulier par un épaulement de la pièce filetée (32).

5. Appareil électrique selon au moins l'une des revendications précédentes,
**caractérisé en ce que**
le composant produisant de la chaleur (34) est disposé dans un évidement traversant de la carte de circuit imprimé (33),
de telle sorte que la portion de support (40) de la partie couvercle servant de surface de support pour la première carte de circuit imprimé (33) est moins espacée de la carte de circuit imprimé (33) que la portion de support (40) de la partie couvercle servant de surface de support pour le composant produisant de la chaleur (34),
dans lequel la portion de support (40) de la partie couvercle qui sert de surface de support pour la première carte de circuit imprimé (33) est en contact avec la carte de circuit imprimé (33), c'est-à-dire présente une distance tendant vers zéro à la carte de circuit imprimé (33).

6. Appareil électrique selon au moins l'une des revendications précédentes,
**caractérisé en ce que**
la partie couvercle (20) présente une fente, en particulier une fente traversante,
dans lequel une portion formant languette de la pièce de tôle (30) fait saillie au moins partiellement dans la fente ou traverse celle-ci.

7. Appareil électrique selon au moins l'une des revendications précédentes,
**caractérisé en ce que**
la partie couvercle (20) présente une portion enfichable (43) qui est adjacente à un épaulement,
dans lequel l'épaulement s'applique contre une portion de la bordure de l'ouverture de la partie boîtier (1),
dans lequel la portion enfichable (43) s'applique contre une zone partielle de la paroi de la partie boîtier (1).

8. Appareil électrique selon au moins l'une des revendications précédentes,
**caractérisé en ce que**
la partie boîtier (1) présente des ailettes de refroidissement pour dissiper la perte de chaleur de composants (34), en particulier de commutateurs à semi-conducteurs commandables, qui sont montés sur la deuxième carte de circuit imprimé (2) ou sont reliés électriquement à celle-ci,
dans lequel un ventilateur est introduit dans une poche de boîtier de la partie boîtier (1), le flux d'air transporté par le ventilateur s'écoulant le long des ailettes de refroidissement de la partie boîtier (1).

9. Appareil électrique selon au moins l'une des revendications précédentes,
**caractérisé en ce que**
l'appareil électrique est un onduleur, un variateur ou une partie de ceux-ci.
